# EUROPÄISCHE PATENTANMELDUNG

(11) **EP 2 124 259 A2**
(43) Veröffentlichungstag der Anmeldung: **25.11.2009**
(21) Anmeldenummer: 08015002.2
(22) Anmeldetag: 25.08.2008
(51) Int. Cl.: H01L 31/0296, H01L 31/18, H01L 27/146

(54) **Cd(Zn)Te basiertes Strahlungswandlermaterial und dessen Verwendung insbesondere für die Röntgen-Computertomografie, Strahlungswandler sowie Strahlungsdetektor und Röntgen-Computertomograf**

(30) Priorität: 21.05.2008 DE 102008024539
(71) Anmelder: Siemens Aktiengesellschaft, 80333 München (DE)
(72) Erfinder: Hackenschmied, Peter, Dr., 90425 Nürnberg (DE); Kuhn, Harald, Dr., 91054 Erlangen (DE); Strassburg, Matthias, Dr., 91054 Erlangen (DE)

(57) **Zusammenfassung**

Die Erfindung betrifft insbesondere ein Strahlungswandlermaterial (10) für die Röntgen-Computertomografie, zur direkten Wandlung von Röntgenstrahlung (R) in elektrische Ladungsträger, umfassend ein dotiertes Halbleitermaterial. Zur Verbesserung der Detektionseffizienz für hohe Quantenflussraten wird vorgeschlagen, dass das Halbleitermaterial dotiert ist mit zumindest einem der folgenden ersten Dotanden Os, Ru, Ir, Rh, Re, Pd, Fe, Ni, Co, zumindest einem der folgenden zweiten Dotanden O, S, Se und mit zumindest einem der folgenden dritten Dotanden B, Al, Ga, In, Tl.

## Beschreibung

Die Erfindung betrifft insbesondere ein zur Verwendung bei der Röntgen-Computertomografie geeignetes Strahlungswandlermaterial.

Zur Erfassung von Röntgen- oder Gammastrahlung sind sog. direkt konvertierende Strahlungswandlermaterialien bekannt. Mit solchen direkt konvertierenden Strahlungswandlermaterialien können einzelne Quantenabsorptionsereignisse erfasst werden. Strahlungsdetektoren, basierend auf solchen Strahlungswandlermaterialien sind auch als sog. zählende Detektoren bekannt. Bei den direkt konvertierenden Strahlungswandlermaterialien handelt es sich in der Regel um Halbleitermaterialien, bei welchen Gamma- oder Röntgenstrahlung in einem einzigen Wandlungsschritt in elektrische Ladungsträger gewandelt wird.

Bei den bisher bekannten direkt konvertierenden Strahlungswandlermaterialien besteht nach wie vor das Problem, dass Quantenabsorptionsereignisse bei vergleichsweise hohen Quantenflussraten von z. B. im Bereich von 10⁸ Röntgenquanten/mm²*s, wie sie in der Röntgen-Computertomografie, insbesondere der humanmedizinischen Röntgen-Computertomografie, üblich sind, quantitativ d. h. zählend nicht in zufriedenstellender Weise, wenn überhaupt, erfasst werden können. Mit den bekannten Strahlungswandlermaterialien können lediglich Quantenflussraten von weniger als 5*10⁷ Röntgenquanten/mm²*s, typischerweise von bis zu 10⁷ Röntgenquanten/mm²*s erfasst werden.

Ausgehend davon soll ein direkt konvertierendes Strahlungswandlermaterial bereitgestellt werden, welches den bei der Röntgen-Computertomografie, insbesondere der humanmedizinischen Röntgen-Computertomografie, auftretenden Quantenflussraten, insbesondere im Bereich von 10⁸ Röntgenquanten/mm²*s gewachsen ist, so dass einzelne Quantenabsorptionsereignisse quantitativ und effektiv erfasst werden können.

Ferner sollen ein entsprechender Strahlungswandler, ein Strahlungsdetektor sowie ein Röntgen-Computertomograf bereitgestellt werden.

Darüber hinaus soll ein Verfahren zur Herstellung eines solchen direkt konvertierenden Strahlungswandlermaterials angegeben werden.

Nach einem ersten Aspekt der Erfindung ist ein für die Röntgen-Computertomografie geeignetes Strahlungswandlermaterial zur direkten Wandlung von Röntgenquanten in elektrische Ladungsträger vorgesehen. Solche Strahlungswandlermaterialien sind auch als direkt konvertierende Strahlungswandlermaterialien bekannt, und werden der Einfachheit halber und ohne Beschränkung der Allgemeinheit im Folgenden auch kurz mit Strahlungswandlermaterialien bezeichnet. Elektrische Ladungsträger in Halbleitermaterialien werden entsprechend der fachüblichen Bezeichnung auch als Elektronen und Löcher bezeichnet.

Das Strahlungswandlermaterial umfasst ein binäres oder tertiäres Halbleitermaterial auf der Grundlage der Elemente Cadmium (Cd) und Tellur (Te) bzw. Cd, Zink (Zn) und Te, wie beispielsweise Cadmium-Tellurid (CdTe) oder Cadmium-Zink-Tellurid (CdZnTe). In Frage kommen als insbesondere Halbleitermaterialien folgender Art: Zn₁₋ₓCdₓSe_{1-y}Te_{y} mit 0 ≤ x ≤ 1 und 0 ≤ y ≤ 1.

Das Halbleitermaterial des erfindungsgemäßen Strahlungswandlermaterials ist dotiert, und zwar mit
- zumindest einem ersten Dotanden der folgenden ersten Gruppe: Osmium (Os), Ruthenium (Ru), Iridium (Ir), Rhodium (Rh), Rhenium (Re), Palladium (Pd), Eisen (Fe), Nickel (Ni), Kobalt (Co);
- zumindest einem zweiten Dotanden der folgenden zweiten Gruppe: Sauerstoff (O), Schwefel (S), Selen (Se); und
- zumindest einem dritten Dotanden der Gruppe-III Elemente des Periodensystems.

Dabei wird unter dem Begriff "dotieren" das gezielte und beabsichtigte Einbringen eines Dotanden in das Halbleitermaterial verstanden. Entsprechendes gilt für alle weiteren, zur gleichen Wortfamilie gehörigen Begriffe. Nicht unter den Begriff dotieren soll das unbewusste und nicht beeinflussbare Einbringen von Stoffen oder Elementen in das Halbleitermaterial subsumiert werden, was beispielsweise durch Verunreinigungen und dgl. hervorgerufen werden kann.

Mit dem erfindungsgemäßen Strahlungswandlermaterial kann durch die ersten und dritten Dotanden erreicht werden, dass elektrisch geladene Störstellen im Halbleitermaterial, wie z. B. Vakanzen oder Zwischengitteratome, welche beispielsweise bei der Herstellung eines Halbleiterkristalls entstehen, effektiv kompensiert oder passiviert werden. Es kann eine zur Detektion hoher Quantenflussraten erwünschte Hochohmigkeit des Strahlungswandlermaterials, beispielsweise bis hin zum Giga-Ohm (GΩ) Bereich, verbunden mit vergleichsweise geringen Dunkelströmen, erreicht werden. Auf Grund dessen ist es im Vergleich zu den Strahlungswandlermaterialien nach dem Stand der Technik möglich, deutlich höhere Quantenflussraten, z. B. im Bereich von 10⁸ Röntgenquanten/mm²*s und darüber, quantitativ zu erfassen, wie sie z. B. bei der humanmedizinischen Röntgen-Computertomografie auftreten. Durch die gesteigerte Detektionseffizienz eignet sich das Strahlungswandlermaterial auch bei der sog. Dual-Energy Computertomografie, bei welcher Röntgenstrahlung zweier zumindest teilweise unterschiedlicher Spektralbereiche verwendet wird.

Für die genannten Halbleitermaterialien, insbesondere für CdTe und CdZnTe, können mit den ersten und dritten Dotanden vergleichsweise nahe dem Leitungsband bzw. Valenzband gelegene, nicht abgesättigte Ladungen neutralisiert werden. Solche Ladungen können beispielsweise aus intrinsischen Störstellen, z. B. flachen Störstellen, eines Halbleiterkristalls hervorgehen. Insbesondere die ersten Dotanden bilden in CdTe bzw. CdZnTe isovalente Störstellen aus. Diese sind elektrisch neutral und besitzen daher vergleichsweise kleine Einfangsquerschnitte für Ladungsträger, wodurch eine Demobilisierung von Ladungsträgern zumindest verringert, und die Ladungsträgerbeweglichkeit und -lebensdauer verbessert werden können.

Durch Verringerung elektrisch geladener Störstellen und dgl., kann vorteilhafter Weise erreicht werden, dass weit weniger, durch Quantenabsorptionsereignisse erzeugte elektrische Ladungsträger im Halbleitermaterial eingefangen bzw. demobilisiert werden. Demobilisierte elektrische Ladungsträger können zu Polarisationseffekten im Halbleitermaterial führen. Solche Polarisationseffekte sind einer effektiven Trennung der durch Quantenabsorptionsereignisse erzeugen Ladungsträger, und damit einer effektiven quantitativen Erfassung von Quantenabsorptionsereignissen abträglich.

Insbesondere bei dem Halbleitermaterial CdTe handelt es sich um einen sogenannten II-VI-Halbleiter, welche, wie der Name bereits andeutet, Gruppe-II und Gruppe-VI Elemente des Periodensystems umfassen.

Die Gitterstruktur der II-VI-Halbleiter kann durch zwei Untergitter beschrieben werden. Eines der Untergitter beschreibt Gitterpositionen der Gruppe-II Elemente, das andere Untergitter beschreibt Gitterpositionen der Gruppe-VI Elemente. Für die Gitterstruktur als solche sind u. a. die kovalenten Radien der jeweiligen Gruppe-II und Gruppe-VI Elemente von Bedeutung.

Wird nun das Gruppe-II Element, wie im vorliegenden Fall Cd, durch ein anderes Element mit unterschiedlichem kovalenten Radius, wie beispielsweise einem ersten oder dritten Dotanden, oder wie in CdZnTe durch Zn ersetzt, so kommt es zu Gitterverspannungen. Solche Gitterverspannungen können zu Gitterdefekten, wie z. B. Versetzungen oder Gitterleerstellen, sog. Vakanzen, führen. Die Gitterdefekte wiederum können die Lebensdauer von Ladungsträgern, d. h. Elektronen und Löchern, im Halbleitermaterial und/oder den Widerstand des Halbleitermaterials drastisch herabsetzen. Das wiederum setzt, wie bereits erläutert, die Detektionseffizienz des Strahlungswandlermaterials herab, was der quantitativen Erfassung der Röntgenstrahlung, insbesondere bei Hochflussbedingungen in der Röntgen-Computertomografie, abträglich ist.

Die ersten und dritten Dotanden werden auf Gitterplätze des Untergitters des Gruppe-II Elements Cd eingebaut. Durch die gleichzeitige Dotierung mit einem ersten und einem dritten Dotanden der ersten bzw. dritten Gruppe wird stets zumindest ein Element eingebaut, welches einen kleineren kovalenten Radius als Cd aufweist.

Die erfindungsgemäß vorgesehenen zweiten Dotanden werden, im Gegensatz zum ersten und dritten Dotanden oder zum Element Zn, auf Gitterplätze des Untergitters des Gruppe VI-Elements, vorliegend Te, eingebaut. Die zweiten Dotanden O, S, Se weisen kleinere kovalente Radien auf als das Gruppe-VI Element Te. Infolgedessen kann durch den Einbau eines zweiten Dotanden der zweiten Gruppe erreicht werden, dass die beiden Untergitter besser aufeinander abgestimmt sind. Das führt zur Verringerung von Gitterverspannungen, und damit einhergehend zur Verringerung, und unter Umständen zur weitgehenden Kompensation von Defekten. Das wiederum wirkt sich im Hinblick auf eine quantitative Erfassung von Röntgenquanten besonders vorteilhaft auf Detektionseffizienz und Detektionseigenschaften aus.

Durch Verringerung intrinsischer Störstellen und durch Verringerung der Gitterverspannung im Halbleitermaterial kann erreicht werden, dass die Wahrscheinlichkeit zur Demobilisierung von Ladungsträgern deutlich herabgesetzt wird. Anders ausgedrückt kann die Beweglichkeit der Ladungsträger im Halbleitermaterial verbessert werden, was insbesondere bei den in der Röntgen-Computertomografie vorherrschenden, vergleichsweise hohen Quantenflussraten von entscheidendem Vorteil ist. Es können kürzere elektrische Pulsdauern erreicht, und damit einhergehend mehr Quantenabsorptionsereignisse pro Zeiteinheit erfasst werden.

Demzufolge ist das erfindungsgemäße Halbleitermaterial insbesondere für den Einsatz unter Hochflussbedingungen, wie z. B. in der Röntgen-Computertomografie, geeignet.

Der zumindest eine dritte Dotand kann aus folgender Gruppe ausgewählt sein: Bor (B), Aluminium (Al), Gallium (Ga), Indium (In), Thallium (Tl).

Die ersten bis dritten Dotanden sind vorzugsweise so ausgewählt, dass sowohl die Anzahl an Störstellen als auch die Gitterverspannung, und damit die Anzahl verspannungsinduzierter Defekte besonders klein sind.

Mit den erfindungsgemäßen ersten bis dritten Dotanden werden chemische Eigenschaften des Halbleitermaterials im Großen und Ganzen nur minimal, wenn überhaupt verändert. Das hat u. a. den Vorteil, dass herkömmliche Techniken, z. B. zur Strukturierung, zur elektrischen Anbindung an Ausleseelektroniken usw., weiterhin verwendet werden können.

Insbesondere für Hochflussbedingungen sind Dotierstoffkonzentrationen der ersten bis dritten Dotanden im Bereich von 10¹¹ bis 10¹⁸ Atome pro cm³, vorzugsweise im Bereich von 10¹⁴ bis 3*10¹⁷ Atome pro cm³, von Vorteil. Es kommen also Dotierstoffkonzentrationen der folgenden Bereiche in Betracht: 10¹¹ bis 10¹², 10¹² bis 10¹³, 10¹³ bis 10¹⁴, 10¹⁴ bis 10¹⁵, 10¹⁵ bis 10¹⁶, 10¹⁶ bis 10¹⁷, 10¹⁷ bis 10¹⁸ Atome pro cm³. Es kann die erforderliche Hochohmigkeit unter gleichzeitiger Vermeidung bzw. Verringerung von Polarisationseffekten erreicht werden.

Der zweite Dotand kann mit einem auf die Gesamtatomzahl bezogenen Anteil von bis zu 10 % oder von bis zu 20% enthalten sein. Bei Verwendung des Halbleitermaterials CdZnTe kann das Element Zn mit einem auf die Gesamtatomzahl bezogenen Anteil von bis zu 30 % enthalten sein.

Ein zweiter Aspekt der Erfindung betrifft einen Strahlungswandler für die Röntgen-Computertomografie, insbesondere für die humanmedizinische Röntgen-Computertomografie, umfassend ein Strahlungswandlermaterial nach dem ersten Aspekt der Erfindung.

Ein dritter Aspekt der Erfindung betrifft einen Strahlungsdetektor mit zumindest einer Detektorkachel mit zumindest einem, vorzugsweise pixeliert ausgebildeten, Strahlungswandler nach dem zweiten Aspekt der Erfindung.

Ein vierter Aspekt der Erfindung betrifft einen Röntgen-Computertomografen, umfassend zumindest einen Strahlungsdetektor nach dem dritten Aspekt der Erfindung.

Nach einem fünften Aspekt der Erfindung ist vorgesehen, dass das Strahlungswandlermaterial nach dem ersten Aspekt der Erfindung bei der Herstellung eines Strahlungswandlers für die Röntgen-Computertomografie, insbesondere die humanmedizinische Röntgen-Computertomografie, verwendet wird.

Auf Grund der vorteilhaften Eigenschaften des Strahlungswandlermaterials nach dem ersten Aspekt, eignet sich dieses insbesondere für die Strahlungsdetektion bei vergleichsweise hohen Quantenflussraten, wie sie bei computertomografischen Untersuchungen am lebenden Menschen auftreten.

Vorteile und vorteilhafte Wirkungen des zweiten bis fünften Aspekts der Erfindung ergeben sich unmittelbar aus den Ausführungen zum ersten Aspekt der Erfindung.

Ein sechster Aspekt der Erfindung betrifft ein Verfahren zur Herstellung eines Strahlungswandlers nach dem zweiten Aspekt der Erfindung. Dabei ist vorgesehen, dass das Strahlungswandlermaterial mittels zumindest einem aus folgender Gruppe ausgewählten Verfahren hergestellt wird: CVD (chemical vapor deposition), MOVPE (metal organic vapor phase epitaxy), MOCVD (meatal organic chemical vapor deposition), ALE (atomic layer epitaxy), MBE (molecular beam epitaxy), THM (travelling heater method), TSM (travelling solvent method), einem Bridgman-Verfahren, insbesondere HPB (high pressure Bridgman), VPE (Vapor Phase Epitaxy).

Bei den angegebenen Verfahren können Halbleitermaterialien durch Schichtabscheidung bzw. durch Bildung von Volumenkristallen hergestellt werden, wobei vorteilhafte Prozesstemperaturen von weniger als 500 Grad Celsius, vorzugsweise im Bereich von 200 Grad Celsius bis 450 Grad Celsius, vorzugsweise im Bereich von 350 Grad Celsius bis 425 Grad Celsius, verwendet werden können. Dabei wird unter der Prozesstemperatur diejenige Temperatur verstanden, unter welcher das Halbleitermaterial hergestellt wird. Bei den vorweg angegebenen Prozesstemperaturen unterhalb von 500 Grad Celsius können besonders defektarme, dotierte Halbleitermaterialien hergestellt werden.

Nachfolgend werden Ausführungsbeispiele der Erfindung anhand der beigefügten Figuren näher beschrieben. Es zeigen:
- Fig. 1: einen Röntgen-Computertomografen nach dem vierten Aspekt der Erfindung mit einem Strahlungsdetektor nach dem dritten Aspekt der Erfindung; und
- Fig. 2: einen pixeliert ausgebildeten Strahlungswandler nach dem zweiten Aspekt der Erfindung mit einem Strahlungswandlermaterial nach dem ersten Aspekt der Erfindung.

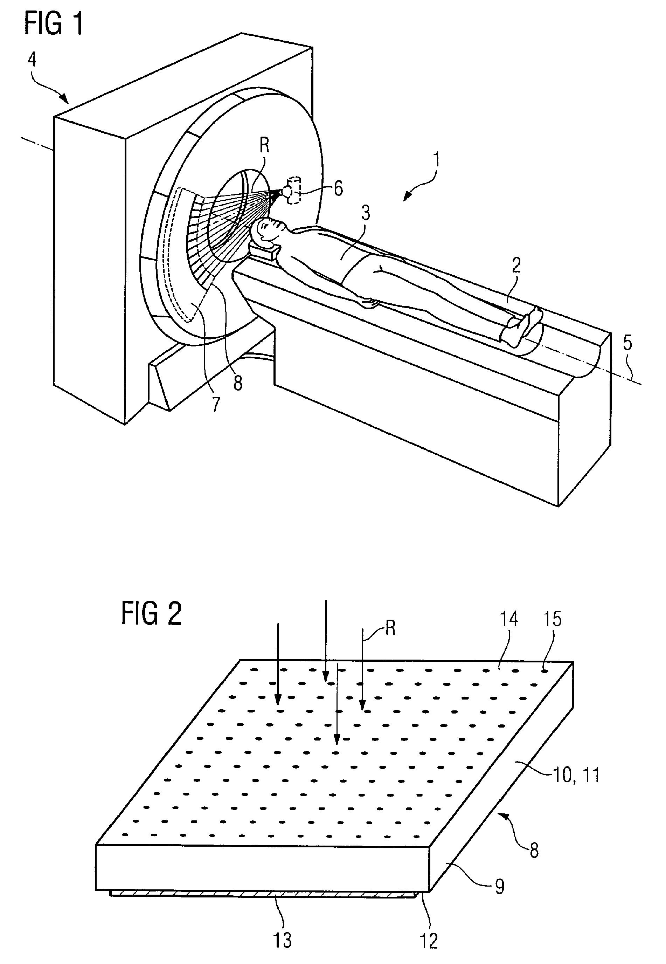

Fig. 1 zeigt einen Röntgen-Computertomografen 1 nach dem vierten Aspekt der Erfindung. Der Röntgen-Computertomograf 1 umfasst einen Patientenlagerungstisch 2 zur Lagerung eines zu untersuchenden Patienten 3. Der Röntgen-Computertomograf 1 umfasst ferner eine Gantry 4, mit einem um eine Systemachse 5 drehbar gelagerten Röhren-Detektor-System. Das Röhren-Detektor-System wiederum umfasst eine Röntgenröhre 6 und einen dieser gegenüber liegend angeordneten Strahlungsdetektor 7 nach dem dritten Aspekt der Erfindung. Der Strahlungsdetektor 7 wiederum umfasst mehrere in einer oder zwei Dimensionen aneinander gereihte Detektorkacheln 8.

Im Betrieb des Röntgen-Computertomografen geht von der Röntgenröhre 6 Röntgenstrahlung R in Richtung des Strahlungsdetektors 7 aus, und kann mit diesem erfasst werden. Die Detektorkacheln 8 können beispielsweise in zur Systemachse 5 azimutaler Richtung und/oder in Richtung der Systemachse 5, kachelartig, aneinander gereiht sein. Sofern nichts anderes erwähnt ist und sich keine widersprüchlichen Aussagen ergeben, werden die Begriffe Röntgenstrahlung und Röntgenquant oder Röntgenquanten im Lichte des Welle-Teilchen-Dualismus gleichberechtigt nebeneinander verwendet.

Fig. 2 zeigt einen pixeliert ausgebildeten Strahlungswandler 9 nach dem zweiten Aspekt der Erfindung. Zumindest ein derartiger Strahlungswandler 9 ist Bestandteil einer jeden Detektorkachel 8. Über den Strahlungswandler 9 hinaus kann jede Detektorkachel 8 zumindest ein, nicht gezeigtes elektronisches Bauelement, wie z. B. einen ASIC (Anwendungsspezifische Integrierte Schaltung bzw. Application Specific Integrated Circuit) zur Verarbeitung elektrischer Signale des Strahlungswandlers 9 umfassen.

Der Strahlungswandler 9 umfasst eine aus einem Strahlungswandlermaterial 10 hergestellte Wandlerschicht 11 zur direkten Wandlung der Röntgenstrahlung R in elektrische Ladungsträger. Insoweit handelt es sich bei dem vorliegenden Strahlungsdetektor 7 um einen sog. direkt konvertierenden Strahlungsdetektor, mit welchem eine quantitative Erfassung von Quantenabsorptionsereignissen möglich ist.

Auf einer ersten Seite 12 der Wandlerschicht 11 ist eine, lediglich schematisch dargestellte, Flächenelektrode 13 in Form einer Metallisierung aufgebracht. Auf einer der ersten Seite 12 gegenüber liegenden zweiten Seite 14 sind in matrixartiger Anordnung Pixelelektroden 15 angebracht.

Es wird darauf hingewiesen, dass die Anordnung der Flächenelektrode 13 und der Pixelelektroden 15 lediglich beispielhaft ist, und keineswegs als einschränkend angesehen werden sollte. Im Rahmen der Erfindung ist es durchaus auch möglich, dass Bestandteile der Flächenelektrode 13 und/oder der Pixelelektroden 15 in der Wandlerschicht 11 parallel zur Detektionsrichtung des Strahlungswandlers 9, d. h. im vorliegenden Fall parallel zur Richtung der einfallenden Röntgenstrahlung R, verlaufen.

Im Betrieb des Strahlungswandlers 9 werden durch Wechselwirkungsprozesse der in die Wandlerschicht 11 eintretenden Röntgenstrahlung R mit dem Strahlungswandlermaterial 10 elektrische Ladungsträger erzeugt. Indem zwischen der Flächenelektrode 13 und den Pixelelektroden 15 eine Spannung angelegt ist, werden die Ladungsträger, d. h. Elektronen und Löcher, zu den jeweiligen Elektroden beschleunigt und induzieren dort elektrische Signale. Die elektrischen Signale können beispielsweise zur Ermittlung einer 2- oder 3-dimensionalen Darstellung eines Abschnitts des Körpers des Patienten 3 verwendet werden.

Das Strahlungswandlermaterial 10 umfasst ein dotiertes CdTe oder CdZnTe Halbleitermaterial, welches dotiert ist mit:
- zumindest einem ersten Dotanden der folgenden ersten Gruppe: Os, Ru, Ir, Rh, Re, Pd, Fe, Ni, Co;
- zumindest einem zweiten Dotanden der folgenden zweiten Gruppe: O, S, Se und
- zumindest einem dritten Dotanden der Gruppe-III Elemente des Periodensystems, wie beispielsweise B, Al, Ga, In, Tl.

Die ersten bis dritten Dotanden sind in einer Konzentration von 10¹¹ bis 10¹⁸ Atome pro cm³, vorzugsweise im Bereich von 10¹⁴ bis 3*10¹⁷ Atome pro cm³ enthalten. Insbesondere kommen die Konzentrationsbereiche 10¹¹ bis 10¹², 10¹² bis 10¹³, 10¹³ bis 10¹⁴, 10¹⁴ bis 10¹⁵, 10¹⁵ bis 10¹⁶, 10¹⁶ bis 10¹⁷, 10¹⁷ bis 10¹⁸ Atome pro cm³ in Betracht. Der zweite Dotand Se kann mit einem auf die Gesamtatomzahl bezogenen Anteil von bis zu 10 % oder von bis zu 20% enthalten sein. Bei dem Halbleitermaterial CdZnTe kann das Element Zn mit einem auf die Gesamtatomzahl bezogenen Anteil von bis zu 30 % enthalten.

Die Vorteile des erfindungsgemäßen Strahlungswandlermaterials 10 liegen, wie weiter oben bereits ausführlich erläutert worden ist, u. a darin, dass:
1) elektrisch geladene, insbesondere intrinsische, Störstellen kompensiert und verspannungsinduzierte Defekte vermieden werden können, wodurch insbesondere die zur quantitativen Erfassung vergleichsweise hoher Quantenflussraten bei der Röntgen-Computertomografie vorteilhafte Hochohmigkeit verbessert werden kann;
2) eine vorteilhafte Ladungsträgerbeweglichkeit für Elektronen und Löchern erreicht werden kann, so dass durch Wechselwirkungsprozesse der Röntgenstrahlung R mit der Wandlerschicht 11 erzeugte Elektronen und Löcher effektiv, d. h. bei vergleichsweise kurzen elektrischen Pulsdauern, quantitativ erfasst werden können;
3) der effektiven Erfassung der Ladungsträger abträgliche, bei Strahlungswandlern nach dem Stand der Technik bei vergleichsweise hohen Quantenflussraten auftretende Polarisationseffekte zumindest weitgehend vermieden werden können, was sich wiederum positiv auf die quantitative Erfassung der Quantenabsorptionsereignisse auswirkt.

Das erfindungsgemäße Strahlungswandlermaterial (10) eignet sich, insbesondere auf Grund der vorgenannten Vorteile, besonders gut für Strahlungsdetektoren 7 für die Röntgen-Computertomografie.

Das Strahlungswandlermaterial 10 kann beispielsweise mittels Verfahren wie CVD, MOVPE, MOCVD, ALE, MBE, THM, TSM, einem Bridgman-Verfahren, insbesondere HPB, oder VPE hergestellt werden. Mit solchen Verfahren können die oben genannten Halbleitermaterialien besonders Defektarm unter Prozesstemperaturen von unter 500 °C, z. B. im Bereich zwischen 200 °C und 450 °C, hergestellt werden.

Aus den obigen Ausführungen wird deutlich, dass die der Erfindung zu Grunde liegenden Ziele erreicht werden.

## Patentansprüche

1. Strahlungswandlermaterial (10) für die Röntgen-Computertomografie, zur direkten Wandlung von Röntgenquanten (R) in elektrische Ladungsträger, umfassend ein binäres oder tertiäres Halbleitermaterial auf der Grundlage der Elemente Cd und Te bzw. Cd, Zn und Te, wobei das Halbleitermaterial dotiert ist mit
- zumindest einem ersten Dotanden der folgenden ersten Gruppe: Os, Ru, Ir, Rh, Re, Pd, Fe, Ni, Co;
- zumindest einem zweiten Dotanden der folgenden zweiten Gruppe: O, S, Se; und
- zumindest einem dritten Dotanden der Gruppe-III Elemente des Periodensystems.

2. Strahlungswandlermaterial (10) nach Anspruch 1, wobei der zumindest eine dritte Dotand aus folgender dritten Gruppe ausgewählt ist: B, Al, Ga, In, Tl.

3. Strahlungswandlermaterial (10) nach Anspruch 1 oder 2, wobei die ersten bis dritten Dotanden im Halbleitermaterial jeweils in einer Dotierstoffkonzentration von 10¹¹ bis 10¹⁸ Atome pro cm³, vorzugsweise im Bereich von 10¹⁴ bis 3*10¹⁷ Atome pro cm³ vorliegen.

4. Strahlungswandlermaterial (10) nach einem der Ansprüche 1 bis 3, wobei das Halbleitermaterial als einen zweiten Dotanden das Element Se mit einem auf die Gesamtatomzahl bezogenen Anteil von bis zu 10 % oder von bis zu 20% umfasst.

5. Strahlungswandlermaterial (10) nach einem der Ansprüche 1 bis 4, wobei es sich bei dem Halbleitermaterial um CdZnTe handelt, und das Element Zn mit einem auf die Gesamtatomzahl bezogenen Anteil von bis zu 30 % enthalten ist.

6. Strahlungswandler (9) für die Röntgen-Computertomografie, insbesondere für die humanmedizinische Röntgen-Computertomografie, umfassend ein Strahlungswandlermaterial (10) nach einem der Ansprüche 1 bis 5.

7. Strahlungsdetektor (7) für die Röntgen-Computertomografie, umfassend zumindest eine Detektorkachel (8) mit zumindest einem, vorzugsweise pixeliert ausgebildeten, Strahlungswandler (9) nach Anspruch 6.

8. Röntgen-Computertomograf (1), umfassend zumindest einen Strahlungsdetektor (7) nach Anspruch 7.

9. Verwendung eines Strahlungswandlermaterials (10) nach einem der Ansprüche 1 bis 5, zur Herstellung eines Strahlungswandlers (9) für die Röntgen-Computertomografie, insbesondere für die humanmedizinische Röntgen-Computertomografie.

10. Verfahren zur Herstellung eines Strahlungswandlers (9) nach Anspruch 6, wobei das Strahlungswandlermaterial (10) mittels zumindest einem aus folgender Gruppe ausgewählten Verfahren hergestellt wird: CVD, MOVPE, MOCVD, ALE, MBE, THM, TSM, einem Bridgman-Verfahren, HPB, VPE.

11. Verfahren nach Anspruch 10, wobei das Strahlungswandlermaterial (10) bei einer Prozesstemperatur von weniger als 500°C, vorzugsweise im Bereich von 200°C bis 450°C, vorzugsweise im Bereich von 350 °C bis 425 °C, hergestellt wird.
